(19) Europäisches Patentamt
European Patent Office
Office européen des brevets

(11) **EP 2 405 663 A1**

(12) **EUROPEAN PATENT APPLICATION**

(43) Date of publication:
**11.01.2012 Bulletin 2012/02**

(51) Int Cl.:
*H04N 13/00* (2006.01)   *G01S 17/89* (2006.01)
*H04N 5/335* (2011.01)

(21) Application number: **10305638.8**

(22) Date of filing: **15.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Thomson Licensing**
**92130 Issy-les-Moulineaux (FR)**

(72) Inventors:
• **Centen, Petrus Gijsbertus Maria**
  **5051 BW Goirle (NL)**

• **Damstra, Nicolaas Johannes**
  **4823 MV Breda (NL)**
• **Rotte, Jeroen**
  **4835 GR Breda (NL)**
• **van den Heijkant, Juul**
  **4942 DC Raamsdonkveer (NL)**

(74) Representative: **Lindemann, Robert**
**Deutsche Thomson OHG**
**European Patent Operations**
**Karl-Wiechert-Allee 74**
**30625 Hannover (DE)**

(54) **Method of driving an image sensor**

(57)    A method for driving a sensor comprises, during a first time interval, generating a first type sensor value (BG) by repeatedly generating alternating periods of sensitivity and insensitivity of at least one pixel of the sensor, and reading out the sensor, and during a second time interval, generating a second type sensor value (O, T) by irradiating the scene facing the sensor with pulses of electromagnetic energy having a wavelength detectable by the sensor and having predefined start times and durations, and repeatedly generating alternating periods of sensitivity and insensitivity of the at least one pixel, and reading out the pixel once again. Generating alternating periods of sensitivity and insensitivity includes repeatedly controlling transfer means (TG) and reset means (GS) of the at least one pixel to alternately enable charge transfer while removing reset from the detector element (PD) and to disable charge transfer while resetting the detector element (PD), respectively.

**Fig. 5**

EP 2 405 663 A1

## EP 2 405 663 A1

**Description**

The invention presented in the following specification pertains to a method of driving an image sensor for creating information relating to the distance between a camera and objects in a scene, or depth information.

In the following specification the terms "information relating to the distance between a camera and objects in a scene" and "depth information" are used interchangeably unless explicitly stated.

An increasing need exists for gathering information relating to the distance between a camera and objects within a scene when capturing film or video sequences. The distance information or depth information is particularly useful during postprocessing, when inserting CGI or computer generated images, special effects and, last not least creating 3D effects and images.

Depth information can be had by using a set of using two cameras arranged side-by-side at a predetermined distance and capturing true stereoscopic images. Numerous ways are known for determining depth information from pairs of images captured in that way. However, a stereoscopic camera set up is expensive and cumbersome to handle.

Capturing a 2-D image and additionally determining a depth map for the scene provides several advantages over using a classic stereoscopic camera setup. Left and right images can be derived in post processing for providing (pseudo-)stereoscopic images at much lower cost. The stereo base for stereoscopic images may also be changed in post processing. Further, different viewing angles for multi-view displays can be derived from the 2-D image and depth data. Having depth information available for each 2-D image eases placing computer graphic effects and objects into a real-world scene in both 2-D and 3-D images. Generally, implementation of video effects in 2-D and 3-D images can be improved using depth information.

Several ways of determining depth information are known including triangulation, use of structured light, or "time of flight", a principle akin to echo-ranging or radar.

All of the above-mentioned methods provide high temporal and spatial resolution and are well suited for capturing images in controlled environments, i.e. indoor shooting. However, the use of structured light may be difficult in certain environments, notably outdoor environments. Environments that are not completely set up for this purpose, e.g. outdoor environments, may not allow for determining the distance between the camera and each and every object visible in the scene. Use of structured light may turn out to be problematic at object borders. Triangulation may face difficulties depending on textures of objects whose distance to the camera is to be determined. Triangulation may also provide less accurate results in case of short distances between the object and the camera.

US 5,081,530 to Medina discloses a three-dimensional camera system in which a precisely timed beam of energy is emitted for illuminating a scene. The reflected energy from the beam is detected with a camera whose sensitivity is precisely timed and synchronised with the emitted beam. Energy reflected from objects in the scene is separated and segregated according to the time of arrival at the camera. The sensitivity of the camera is timed using a shutter located in front of the lens of the camera.

However, the need for a shutter in front of the lens of a camera increases the complexity of the system and introduces additional components to the system which need to be tightly controlled in order to provide the desired results.

It is desirable to provide an improved method of operating a sensor for obtaining information relating to the distance of objects in a scene to a camera.

In accordance with the invention, a method of controlling an image sensor is presented, which dispenses with the need of a shutter in front of the lens of the camera while providing the desired depth information.

Several ways of controlling electronic imagers are known, including rolling shutter and global shutter. Rolling shutter refers to exposing an image sensor by moving a narrow slit across the image sensor, which slit allows for light to pass on to the sensor or film. The whole light-sensitive area of the sensor is exposed once the slit has been completely moved across the sensor or the film. Rolling shutter exposure may also be had by accordingly controlling readout of an electronic image sensor, moving a virtual slit across the sensor by correspondingly making lines of the sensor light sensitive in a sequential manner. Using a rolling shutter-type exposure may produce image distortions in case of moving objects, because the image is exposed line-by-line in a sequential fashion.

Imagers using a global shutter capture the whole scene simultaneously and thus do not produce image distortions caused by moving objects. Imagers using a global shutter typically have a higher number of transistors for each pixel than imagers using a rolling shutter, although any imager having a higher number of transistors can be driven in a rolling shutter manner. Also, imagers capable of performing global shutter function typically have a storage means, e.g. a capacitor or the like, which provides intermediate storage associated to each pixel for charges representing the image captured. Providing intermediate an charge storage means with each pixel allows for simultaneously transferring the charges representative of an image that are captured during the integration time by the photosensitive elements of all pixels into the respective associated charge storage means, from where the charges can be read out in an ordered manner. Once stored in the storage means these charges are not changed until the next exposure cycle for the next image is over, which allows for reading out the sensor in a sequential manner despite of capturing all pixels of the image at once.

Imagers using a global shutter can produce very short exposure times and thus greatly reduce motion blur caused by long exposure.

Global shutter also allows for resetting all pixels simultaneously. Advanced imager technology provides two read out values for each pixel of an image, a dark value and a bright value, and the actual image can be calculated from the difference between the dark value and the bright value. This is also referred to as correlated double sampling, or CDS, sometimes also as double data sampling, or DDS, and helps reducing noise caused by imperfections of the imager or the associated circuitry.

When determining a depth map for a captured image using "time of flight" first a light pulse is emitted onto the scene, and total reflection is measured as well as the reflected light is measured within a certain predefined time window. This measurement provides a value representative of the amount of light that is reflected by various objects in the scene, and allows for compensating different reflexion coefficients of different objects. As the speed of light is known the distance between the camera and an object can be determined by the time it takes for the reflected light to be detected in a detector positioned close to the camera. The influence of ambient light on the measurement can be reduced or compensated for by accordingly measuring and considering an intensity distribution of the background light across the scene when determining the depth map.

All three measurements are performed for all pixels simultaneously and using a sequence of light pulses. The repetition rate of the light pulses depends on the maximum distance of an object of the camera, since it must match the time window required for capturing the reflected light, and on the speed of the imager. The need for a measuring all pixels simultaneously mandates using an imager capable of global shutter function.

The light pulses are preferably emitted in the infrared range, although other frequency or wavelength ranges of electromagnetic radiation can be used, depending on the capability of the sensor to detect the radiation. The frequency or wavelength range may be chosen to be relatively narrow, depending on the steepness and bandwidth of filters that may be required in case of sensors sensitive in a broad frequency or wavelength range. Narrow range electromagnetic radiation is particularly advantageous in case a single sensor is used for capturing an image in the visible range as well as in the range used for determining depth information.

Run time differences within the sensor, also referred to as shading, can be determined for each pixel of an imager by capturing an image of a flat surface with uniform reflexion coefficient located at a known distance and determining the depth map for these images. The runtime differences determined for the sensor will then be used for correcting the depth data captured by the sensor prior to or when determining the depth map for an image.

Values for vertical and horizontal variation can be determined by line averaging or column averaging. Line and column averaging can be complemented by averaging over a number of consecutive frames.

Experimental results show that the depth measurements are widely independent from the reflection coefficient of objects as long as the reflection coefficient is not too small, which would reduce the level of the reflected light below a minimum threshold that may be required by the sensor.

One or more embodiments of the inventive method described in the following advantageously allow for using existing sensors without reducing the sensor's capability to capture regular video signals.

A sensor operated in accordance with the inventive method has at least one pixel, each pixel having a detector element that is adapted to detect electromagnetic energy. The pixel further includes a storage node, as well as first and second reset means adapted to selectively reset or remove the reset from the detector element and the storage node, respectively. Yet further, the pixel includes transfer means adapted to selectively enable or disable charge transfer from the photosensitive element to the storage node, and readout means adapted to selectively read out the storage node.

The sensor is adapted to sample a scene facing the sensor during a predetermined first time interval. In accordance with one or more embodiments of the invention, the sensor may be provided with means for reproducing the scene on the sensor, such as, in case of use of electromagnetic energy or radiation of a frequency from a spectrum commonly referred to as light - including ultraviolet, infrared and visible light - , optical means including lenses, prisms and the like. In case of use of electromagnetic radiation of other frequencies, other means for reproducing the scene onto the sensor may be used, including waveguides, reflectors, separators, concentrators, and the like.

In accordance with an embodiment of the present invention, a method of operating a sensor for sampling a scene during a first time interval includes generating, during a second time interval, a first type sensor value by repeatedly generating alternating periods of sensitivity and insensitivity of the at least one pixel, followed by reading out the pixel after the end of the second time period. The method further includes generating, during a third time interval, a second type sensor value by irradiating the scene facing the sensor with pulses of electromagnetic energy having a wavelength detectable by the detector element and having predefined start times and durations, and repeatedly generating alternating periods of sensitivity and insensitivity of the at least one pixel, followed by reading out the pixel after the end of the third time period. Generating alternating periods of sensitivity and insensitivity of the at least one pixel includes repeatedly controlling the transfer means and the first reset means of the at least one pixel to alternately enable charge transfer while removing the reset from the detector element and to disable charge transfer while resetting the detector element, respectively. Reading out the pixel includes selectively reading out the storage node via the readout means. The second and third time intervals are sub-intervals each having a maximum duration not exceeding the first time interval.

In accordance with the invention, when generating the second type sensor values, begin and duration of the pulses of electromagnetic energy and begin and duration of periods of sensitivity of the at least one pixel are adjusted with respect to each other. A value representative of maximum reflection of irradiated energy can be obtained when the duration of the pulses of electromagnetic energy is shorter than the period of sensitivity and begin and end of the pulses of electromagnetic energy are selected such that they are completely nested within the periods of sensitivity. A guard time at the end of the period of sensitivity is to be maintained in order to account for the maximum run time of the electromagnetic pulse from the source to a reflecting object in the scene and back to the sensor. A value representative of the distance of objects in the scene facing the sensor can be obtained when the period of sensitivity coincides with the duration of the pulses of electromagnetic energy or when the pulse of electromagnetic energy and the period of sensitivity are subsequent to each other or partly overlapping, the latter lagging the former.

In an embodiment of the invention the second and third time intervals are non-overlapping sub-intervals of the first time interval. The detector element and the storage node of the least one pixel are reset prior to generating the first type sensor value, and the first and second type sensor values are consecutively generated. The first type sensor value is representative of reset noise and background radiation, and the second type sensor value is representative of the sum of reset noise, background radiation received when generating the first and the second type sensor values, and information representative of the distance of objects or total reflection.

In another embodiment of the invention the second and third time intervals are non-overlapping sub-intervals of the first time interval. The detector element and the storage node of the at least one pixel are reset prior to generating the first type sensor signal. Then the first type sensor values are generated. After generating the first type sensor values, and prior to generating the second type sensor values, the detector element and the storage node of the at least one pixel are reset. The first type sensor value is representative of reset noise and background radiation, and the second type sensor value is representative of the sum of reset noise, background radiation received when generating the second type sensor value, and information representative of the distance of objects or total reflection.

In yet another embodiment of the invention the sensor has multiple pixels arranged in a line and the second and third time intervals are coinciding intervals within the first time interval. The detector elements and storage nodes of the multiple pixels are reset prior to controlling every other pixel in the line so as to produce a first type sensor value only, the other pixels of the line being controlled to produce second type sensor values only.

In a further embodiment of the invention the pixels producing only first type sensor values are controlled so as to be in a status of insensitivity during periods starting with the begin and ending after the end of the pulses of electromagnetic radiation irradiating the scene.

In another embodiment of the invention the sensor has multiple pixels arranged in an array comprising lines and columns. Pixels of adjacent lines are controlled to provide second type sensor values that either include information about the total reflection of irradiated energy or information representative of the distance of objects.

The sensor adapted to be controlled in accordance with the inventive method may be CMOS image sensor, the first reset means of the sensor comprising a first transistor connected between a first supply voltage and the detector element. The transfer means comprises a second transistor connected between a second supply voltage and the storage node. Resetting and removing the reset, and enabling and disabling charge transfer, respectively, is performed by accordingly controlling a respective control electrode of the first or second transistor so as to put the first or second transistor into conducting or non-conducting state.

In one embodiment the sensor adapted to be controlled in accordance with the inventive method has pixels arranged in lines and columns and is provided with a colour filter arrangement, which filters the light projected onto the sensor in such a way that individual pixels only receive light of one of the three primary colours or infrared light. The colour filter arrangement may be arranged in accordance with the known Bayer pattern, or similar patterns, with interspersed pixels which receive infrared light only. In this case, only those pixels adapted to only receive infrared light are read out in accordance with the inventive method.

A camera provided with the sensor described in the preceding paragraph requires only a single sensor for capturing colour images as well as depth information, i.e. information relating to the distance between the camera and objects in the scene.

In a camera provided with individual sensors for each primary colour and an infrared sensor, only the infrared sensor may be controlled in accordance with the inventive method. Likewise, in a camera provided with a single sensor for capturing colour images and an additional infrared sensor, only the infrared sensor may be controlled in accordance with the inventive method.

A sensor to be controlled in accordance with the inventive method may also be adapted to capture only light of one of the primary colours and, in addition, electromagnetic radiation within a narrow spectral range corresponding to the spectral range of the pulses of electronic radiation irradiating the scene, e.g. infrared light. This type of sensor, when controlled in accordance with the inventive method, will provide first type sensor values including a colour signal plus the background radiation in the spectral range used for determining information relating to the distance between the camera and objects in the scene, and second type sensor values including the colour signal plus the background radiation in the spectral range used for determining information relating to the distance between the camera and objects in the scene plus information relating to the distance or total reflection.

In one embodiment, the sensor adapted to capture red light is also adapted to capture infrared light. However, the sensors adapted to capture green or blue light may likewise be adapted to capture infrared light.

In a camera having individual sensors for each of the three primary colours one or more sensors may be adapted to provide colour image signals and depth information. In a camera having only one sensor for capturing full colour images and having colour filters for respective primary colours associated with individual pixels of that sensor, pixels for one or more colours may be adapted to additionally provide depth information.

As already introduced further above, for calculating the depth-value of a pixel using the "time of flight"-method, the following values have to be measured:

1) A signal proportional to the amount of total reflected light
2) A signal proportional to the total reflected light and distance between camera and object, or, in other words, the length of the path between light source, object and camera
3) A signal proportional to the background illumination in the specific frequency or wavelength range

In a CMOS image sensor dedicated to time-of-flight measurements, dedicated pixel constructions are used for performing these measurements. A regular CMOS image sensor for capturing 2D images does not have a priori pixels capable of performing time-of-flight measurements. However, the inventive method of controlling the sensor allows for obtaining a depth map on a pixel to pixel basis.

The invention allows for using off-the-shelf 5-T CMOS imagers having 5 transistors per pixel to be controlled in accordance with the inventive method for generating a depth map of a scene.

In the following, the invention will be described with reference to the drawing. In the drawing

Fig. 1    shows a pixel of a known 5-T CMOS image sensor;
Fig. 2    exemplarily shows the average pixel output as a function of time shift between pulses irradiated onto the scene and corresponding periods of sensitivity of the image sensor;
Fig. 3    shows control signals applied to various components of the 5-T CMOS image sensor of figure 1;
Fig. 4    shows a section of an images sensor driven in accordance with the invention;
Fig. 5    shows an exemplary timing and arrangement of the various measurements during one frame in accordance with the invention;
Fig. 6    shows an exemplary driving scheme in accordance with the invention, in which pixels in a row can be driven independently from each other; and
Fig. 7    shows an exemplary timing and arrangement of the various measurements during one frame for the driving scheme of figure 6.

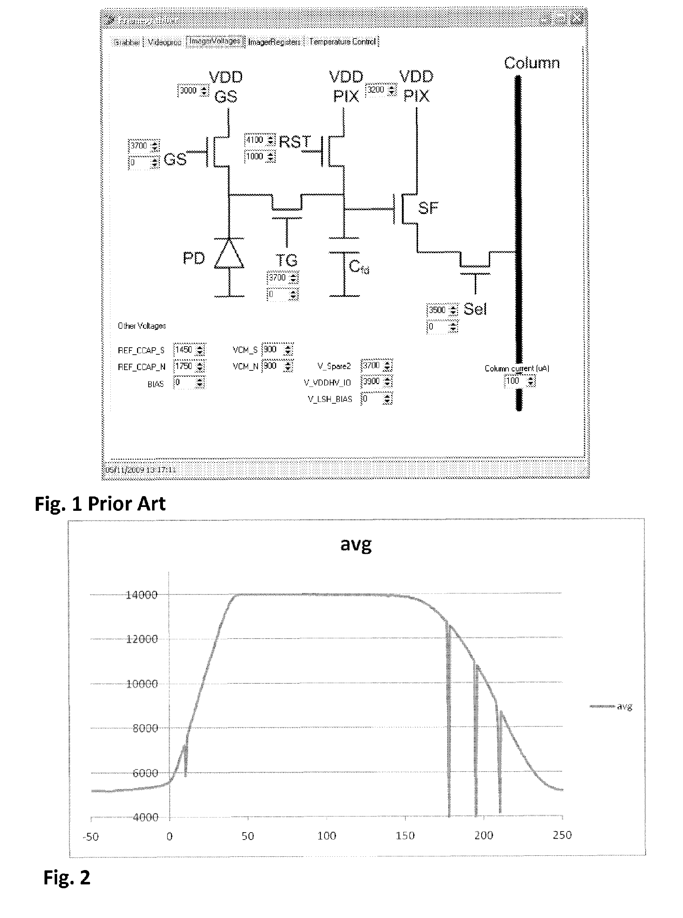

Fig. 1 shows a pixel of a commonly known 5-T CMOS image sensor that can be operated in accordance with the invention. The pixel has a reset means GS, which may also be termed global shutter gate, arranged between a supply voltage VDD_GS and a detector element PD. In the figure detector element PD is a photo diode. One function of the global shutter gate is resetting the photo diode PD. The pixel further has a transfer means TG for selectively transferring a charge from the photo diode PD to a storage node CFD. The storage node is also referred to as floating diffusion, and the transfer means TG may be implemented as transfer gate.

Even though GS and TG are drawn as field effect transistors FET they may in fact be considered as CCD elements. CCD elements allow for transferring the complete charge without generating additional noise. RST, SF and SEL may be implemented as regular field effect transistors.

By applying pulses to global shutter gate GS and corresponding inverted pulses to transfer means TG photodiode PD is either light sensitive and charge is transferred to storage node FD, e.g. when TG=high and GS=low, or photodiode PD effectively is not light sensitive and is reset through reset means GS, while no charge is transferred to storage node FD, e.g. when TG=low and GS=high. Switching in such a fashion allows for photodiode PD to demodulate modulated light.

By choosing proper timings for the duration of light pulses irradiated onto the scene in relation to the duration and position of the GS, TG pulses it is possible to measure background BG, total reflected light TR, and reflected light and distance D. Background BG refers to the signal received by the sensor without light pulses being irradiated onto the scene and also includes reset noise. Total reflected light TR refers to a signal representative of the maximum reflexion of the light pulses irradiated onto the scene that can be measured at the sensor, which can be used for normalising purposes. Reflected light and distance D refers to a signal containing information about the distance between the camera and the objects in the scene based upon the received reflected light pulses.

The distance can be calculated as

$$Distance = (D-BG)/(TR-BG)*dmax$$

where dmax is determined by the duration of the light pulse.

For example, when the scene is irradiated with light pulses or flashes having a duration of 200ns then

The division by 2 is required because the distance between the camera and the object is half of the total distance the light travels from light-source to the object and back to the camera. It is assumed that the source of the light pulses and the camera are located adjacent to each other.

This implementation needs a sequence of 3 images to calculate the depth map, since three different values need to be determined.

In an embodiment of the invention the image sensor is divided into odd and even rows or TV lines. In this embodiment the odd rows are used for measuring the total reflected light TR and the even rows are used for measuring the reflected light and distance D, or vice versa. Background signals BG can be measured in a subsequent image in both odd and even rows. The distance is calculated using the same formula as presented further above.

In this embodiment, only two - preferably consecutive - images are needed for calculating the depth map.

This embodiment requires independently driving reset means GS and transfer means TG for odd and even rows.

Another embodiment makes use of Digital Double Sampling, or correlated double sampling. In this embodiment, at the beginning of a frame all photodiodes PD and storage nodes CFD are reset. Then, during one quarter of a frame time a background charge image BG is built up at the photo diode. After the background charge image BG has been built up, the charge is transferred from photo diode PD to the storage node CFD. The charge BG+RR1 so obtained includes information about background signals BG as well as the reset noise RR1 that is present immediately after reset.

During the next quarter of the frame time the background image BG+RR1 is readout and stored in an external memory. During this time the photo diode PD is kept in reset and the transfer means TG is off to enable proper readout.

Then the storage node CFD is reset again and during the next quarter of a frame time the charges representative of depth information D+BG+RR2 and the total reflected light TR+BG+RR2 build up in the odd and even rows, respectively. Charge D+BG+RR2 referred to as being representative of depth information also includes background radiation BG received during exposure as well as reset noise RR2. Likewise, charge TR+BG+RR2 referred to as being representative of total reflected light includes background radiation BG received during exposure as well as reset noise RR2. Reset noise components RR1 and RR2 for each respective pixel are not correlated and therefore treated as individual values. At the end of this period photo diode PD is kept in reset and the transfer means TG is off for enabling proper readout.

The method described above allows for gathering all information needed for deriving a depth map during one frame time. As the second reset is issued between acquisition of background and depth signal, and due to RR1 and RR2 not being correlated, reset-noise RR is not suppressed and the image contains more noise. Depth information can be determined as

$$DEPTH = (D+BG+RR2-(BG+RR1)) / (TR+BG+RR2 - (BG+RR1))$$

or

$$DEPTH = (D+RR2-RR1) / (TR+RR2-RR1)$$

It goes without saying that, in case adjacent rows can be controlled in independently from each other, it is possible to determine background noise in a first row, information representative of depth in the next row, and information representative of the total reflection in a following row simultaneously. In case individual pixels in one row can be controlled independently from each other while that row is addressed is likewise possible to distribute pixels generating background noise signals, information representative of depth and information representative of the total reflection across the complete sensor and generating respective signals simultaneously.

In a development of the preceding embodiment the second, intermediate reset is not needed if the background illumination is low enough not to saturate the photodiode. In that case noise is reduced by 3dB. Depth information can be determined as

$$DEPTH = (D-RR1) / (TR-RR1)$$

According to an aspect of the invention a camera having an image sensor controlled in accordance with the inventive method runs at double speed and generates one image with depth information and another, subsequent image representative of the standard RGB colour video information.

In Figure 2 the average pixel output is shown as a function of time shift between the light pulse used for illuminating the scene and the pulses applied to GS and TG. GS and TG are switched simultaneously but with inverse signals. The curve shown in figure 2 has been obtained by driving GS and TG high during 1 us and low during 1 us, thereby generating respective times of sensitivity and insensitivity of the sensor. The driving pulses are repeated during an active line time and suppressed during readout. The light source illuminating the scene is switched on during repeated time periods of 200ns and is shifted in time with respect to the GS and TG pulses. This time shift emulates a depth measurement. It is an easy method for determining if everything performs well and for finding optimal timing settings for obtaining background, total reflected and depth images.

In figure 2, the x-axis represents the time shift of the light pulses with respect to the GS and TG pulse in steps corresponding to changes in the distance between the camera and the reflective object of 1 m. The vertical axis is the average signal per pixel. At, for instance, x=75 the curve is flat indicating that the information about distance is absent and that total reflected light is being measured. At for instance x=25 the curve has a linear slope and the average signal per pixel contains the amount of total reflected light plus depth information. Finally at for instance x=-50 (minus 50) the background is measured. The part between 150 and 225 is not usable because of its parabolic shape which is mainly influenced by the switching behaviour of the image sensor and on-chip electronics.

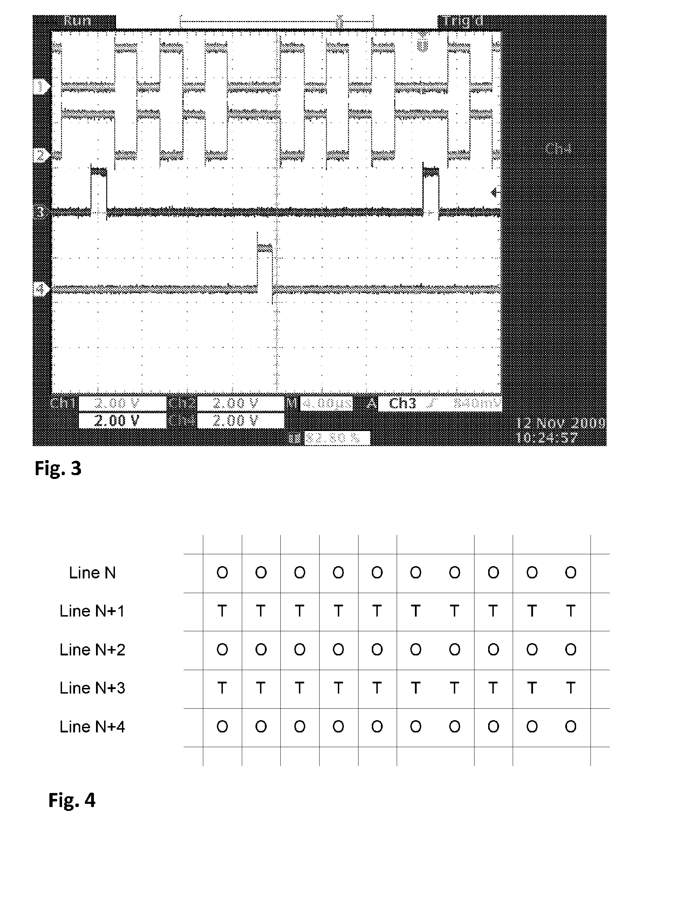

Figure 3 shows control signals applied to various components of the 5-T CMOS image sensor of figure 1 in a rolling shutter driving mode. The signals are, from top to bottom TG, GS, SEL1, SEL2 during one line, SEL2 being applied to the next line. It is apparent that GS and TG are inverted with respect to each other, and that the pulses are stopped during readout of the pixels, i.e. SEL1 and SEL2 high.

Figure 4 shows a section of an image sensor having pixels arranged in rows and columns and being driven in accordance with one embodiment of the invention. Odd lines are driven independently from even lines. In the exemplary embodiment shown in the figure even lines are used for measuring the overlap O between the reflected light pulse and the transfer gate of the CMOS imager, i.e. reflected signals indicative of the distance between the camera and the reflecting object. Odd lines are used for measuring total reflection T of the emitted light pulse. The timing required for measuring the respective different values has been discussed further above.

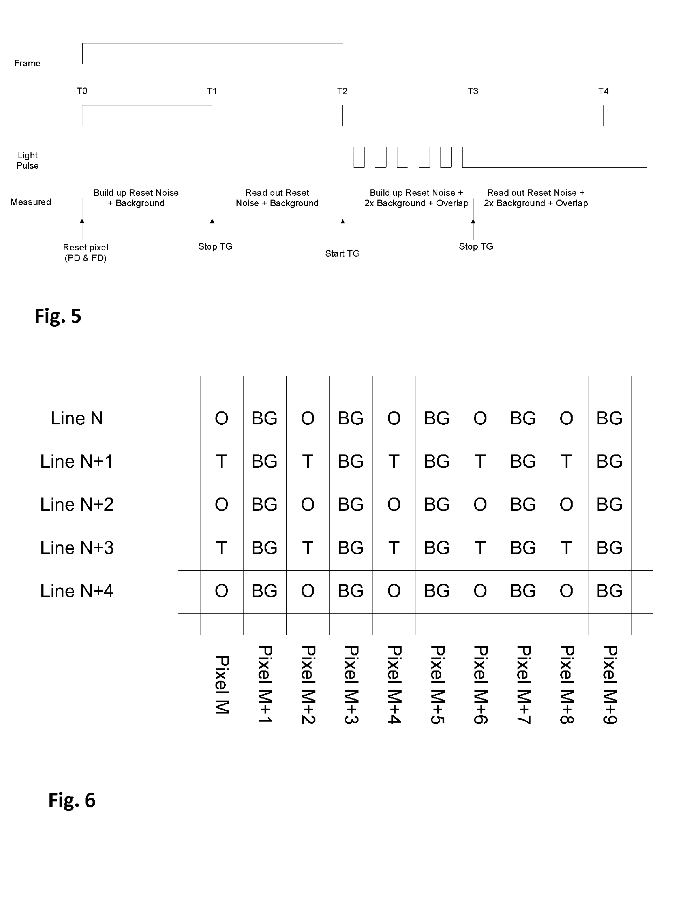

Figure 5 shows an exemplary timing and arrangement of the various measurements during one frame period, including sub periods T0 - T4, in accordance with the invention and in accordance with the driving pattern shown in figure 4. Components of the pixel that are referred to hereinafter are referenced in the same way as in figure 1, the various signals are referred to using the same references as further above. At T0 photodiode PD and storage node CFD of the pixel are reset. The signal present at photodiode PD and storage node CFD represents reset noise RR. During sub-period T0 - T1 the pulsed light source does not emit light, thus photodiode PD accumulates background signal BG on top of reset noise RR. During sub-period T0 - T1 TG and GS toggle in a periodic fashion in accordance with the invention.

At T1 transfer means TG and reset means GS stop toggling so that storage node CFD holds background signal BG plus reset noise RR. In the following sub-period T1 - T2 of the frame period the result of all pixels of the sensor is read out.

At T2, exactly after half a frame period, the light source starts emitting pulsed light and transfer means TG and reset means GS start toggling again. The pixel accumulates, during sub-period T2 - T3, on top of the signal accumulated in sub-period T0 - T1, in even numbered lines the reflected light pulses including distance information and in odd numbered lines the total reflection.

At T3 transfer means TG and reset means GS stop toggling again, so that storage nodes CFD hold two times the background signal BG plus reset noise RR plus integrated overlap O or total reflection T, depending from the location in an odd or even line. In sub-period T3 - T4 the accumulated values are read out once again.

The duration of sub-period T0 - T1 preferably equals the duration of sub-period T2 - T3. The duration of sub-period T1 - T2 preferably equals the duration of sub-period T3 - T4. Generally, the duration of the individual subperiods depends on the frame rate and the maximum read-out speed of the sensor.

When driving in accordance with correlated double sampling, or CDS, or digital double sampling using externally stored intermediate values, or DDS, the values that can be calculated are:

$$\text{VT4} - 2 \times \text{VT2} = [\text{Vreset} + 2\text{Vbackground} + \text{Vdepth}] - 2 \times [\text{Vreset} + \text{Vbackground}]$$
$$= \text{Vdepth} - \text{Vreset}$$

In a development of the driving scheme described in the preceding paragraphs, the same pulse pattern as shown in figure 5 is used, but at T2, after reading out the pixel, photodiode PD and storage node CFD are reset. In that case, at T2, reset noise RR1 plus background BG1 are read out, just as described before. At T4 the value read out corresponds to reset noise RR2 plus background signal BG2 accumulated over the second half of the frame plus the overlap signal O accumulated during the second half of the frame.

The values that can be calculated in this case are:

$$\left| \text{VT4} - \text{VT2} \right| = [\text{Vreset2} + \text{Vbackground2} + \text{Vdepth}] - [\text{Vreset1} + \text{Vbackground1}]$$
$$= \text{Vdepth} - \text{Vreset} \times \sqrt{2}$$

It is assumed that background signals BG1 and BG2 are equal. Reset noise values RR1, RR2 are not correlated, which is taken into consideration by the factor $\sqrt{2}$.

Figure 6 shows a driving scheme in accordance with the invention, in which pixels in a row can be driven independently from each other. Every other pixel in a row is used for determining the background signal BG only, while the other pixels are used for determining depth signals O or total reflection T, depending on whether they are located in an even or odd row.

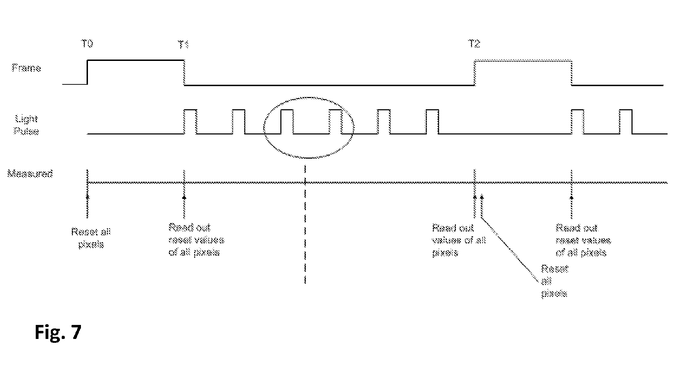

Figure 7 shows an exemplary timing and arrangement of the various measurements during one frame for the driving scheme of figure 6. At T0 all pixels are reset and in the sub-period T0 - T1 the reset values RR of all pixels are read out. At T1 the light source starts emitting light pulses and the transfer means TG and reset means GS for photodiodes PD start toggling in such a way that the pixels T selected to provide values for total reflection accumulate the total reflection of the emitted light pulses plus background signal BG during the accumulation period, the pixels O selected to provide overlap signals accumulate the overlap reflection of the emitted light pulses plus background signal BG, i.e. depth related information, during the accumulation period, and the pixels selected to provide background information BG accumulated the background signal BG during the accumulation period. After DDS values for total reflection + 2 x BG, depth + BG, and BG can be calculated.

The invention advantageously allows for using a pixel for both generating regular 2D pictures and creating a depth-value. This allows for creating depthmaps in regular 2D cameras by simply changing the driving of the image sensor. In cameras having three image sensors, one for each primary colour, an additional advantage is apparent in that there is proper matching between the depth-map and the regular 2D video. Additional video processing steps to further enhance the depth-map can take advantage of this. The added 3D functionality is not influencing regular 2D image capture.

**Claims**

1. A method of operating a sensor having at least one pixel, each pixel having a detector element (PD) that is adapted to detect electromagnetic energy, a storage node (CFD), first and second reset means (GS, RST) adapted to selectively reset or remove the reset from the detector element (PD) and the storage node (CFD), respectively, transfer means (TG) adapted to selectively enable or disable charge transfer from the detector element (PD) to the storage node (CFD), readout means (SF, SEL) adapted to selectively read out the storage node (CFD), wherein the sensor is adapted to sample a scene facing the sensor during a predetermined first time interval (Frame), the method comprising:

- during a second time interval, generating a first type sensor value (BG) by repeatedly generating alternating periods of sensitivity and insensitivity of the at least one pixel, followed by reading out the pixel after the end of the second time period; and
- during a third time interval, generating a second type sensor value (O, T) by irradiating the scene facing the sensor with pulses of electromagnetic energy having a wavelength detectable by the detector element and having predefined start times and durations, and repeatedly generating alternating periods of sensitivity and insensitivity of the at least one pixel, followed by reading out the pixel after the end of the third time period;

wherein generating alternating periods of sensitivity and insensitivity of the at least one pixel includes repeatedly controlling the transfer means (TG) and the first reset means (GS) of the at least one pixel to alternately enable charge transfer while removing the reset from the detector element (PD) and to disable charge transfer while resetting the detector element (PD), respectively, and wherein reading out the pixel includes selectively reading out the storage node (CFD) via the readout means (SF, SEL).

2. The method of claim 1, including, when generating the second type sensor values, adjusting begin and duration of the pulses of electromagnetic energy and begin and duration of periods of sensitivity of the at least one pixel with respect to each other,
wherein a value representative of a maximum reflection of irradiated energy can be obtained when the duration of the pulses of electromagnetic energy is shorter than the period of sensitivity and begin and end of the pulses of electromagnetic energy are selected such that they are completely nested within the periods of sensitivity, wherein a guard time at the end of the period of sensitivity is maintained in order to account for the run time of the electromagnetic pulse from the source to a reflecting object in the scene and back to the sensor, and
wherein a value representative of the distance of objects in the scene facing the sensor can be obtained when the period of sensitivity coincides with the duration of the pulses of electromagnetic energy or when the pulse of electromagnetic energy and the period of sensitivity are subsequent to each other or partly overlapping, with the latter period lagging the former.

3. The method of claim 2, wherein the second and third time intervals are non-overlapping sub-intervals of the first time interval, further including:

- resetting the detector element (PD) and the storage node (CFD) of the at least one pixel prior to generating the first type sensor value; and
- consecutively generating the first (BG) and second (O, T) type sensor values,

wherein the first sensor value (BG) is representative of reset noise and background radiation, and wherein the second sensor value (O, T) is representative of the sum of reset noise, background radiation received when generating the first and the second type sensor values, and information representative of the distance of objects or total reflection.

4. The method of claim 2, wherein the second and third time intervals are non-overlapping sub-intervals of the first time interval, further including:

- resetting the detector element (PD) and the storage node (CFD) of the at least one pixel prior to generating the first type sensor signal;
- generating the first type sensor values;
- resetting the detector element (PD) and the storage node (CFD) of the at least one pixel after generating the first type sensor values (BG) and prior to generating the second type sensor values (O, T);
- generating the second type sensor values,

wherein the first type sensor value (BG) is representative of reset noise and background radiation, and wherein the second type sensor value (O, T) is representative of the sum of reset noise, background radiation received when generating the second sensor value, and information representative of the distance of objects or total reflection.

5. The method of claim 2, wherein the sensor has multiple pixels arranged in a line, and wherein the second and third time intervals are coinciding intervals within the first time interval, further including:

- resetting the detector elements (PD) and the storage nodes (CFD) of the multiple pixels;
- controlling every other pixel in the line so as to produce a first type sensor value (BG) only, the other pixels of the line producing second sensor type values (O, T) only.

6. The method of claim 5, wherein the pixels producing only first type sensor values are controlled so as to be in a status of insensitivity during periods starting with the begin and ending after the end of the pulses of electromagnetic radiation irradiating the scene.

7. The method of any one of claims 3 to 6, wherein the sensor has multiple pixels arranged in an array comprising lines and columns, further including controlling pixels of adjacent lines to provide second type sensor values that either include information about the total reflection of irradiated energy or information representative of the distance of objects.

8. The method of any one of the preceding claims, wherein the sensor is a CMOS image sensor, wherein the first reset means (GS) comprises a first transistor connected between a first supply voltage (VDD_GS) and the detector element (PD), wherein the transfer means (TG) comprises a second transistor connected between a second supply voltage (VDD_PIX) and the storage node (CFD), and wherein resetting and removing the reset, and enabling and disabling charge transfer, respectively, is performed by accordingly controlling a respective control electrode of the first or second transistor so as to put the first or second transistor into conducting or non-conducting state.

9. An image sensor having pixels arranged in rows and columns, wherein the sensor has a colour filter arrangement so as to create individual pixels that are sensitive for light of one primary colour only, wherein the sensor has pixels for each primary colour, and wherein the colour filter arrangement is adapted to create individual pixels exclusively sensitive to electromagnetic energy that is irradiated onto a scene captured by the sensor, wherein the pixels exclusively sensitive to electromagnetic energy that is irradiated onto the scene are controlled in accordance with the method of one of claims 1 to 8.

10. An image sensor having pixels arranged in rows and columns, wherein the sensor has a colour filter arrangement so as to create pixels that are sensitive for light of one primary colour, wherein the filter arrangement is adapted to block light of the other primary colours, wherein the filter arrangement is adapted pass on electromagnetic energy that is irradiated onto a scene captured by the sensor, and wherein the image sensor is controlled in accordance with the method of one of claims 1 to 8.

11. A camera having an image sensor having at least one pixel, each pixel having a detector element (PD) that is adapted to detect electromagnetic energy, a storage node (CFD), first and second reset means (GS, RST) adapted to selectively reset or remove the reset from the detector element (PD) and the storage node (CFD), respectively, transfer means (TG) adapted to selectively enable or disable charge transfer from the detector element (PD) to the storage node (CFD), readout means (SF, SEL) adapted to selectively read out the storage node (CFD), wherein the sensor is adapted to sample a scene facing the sensor during a predetermined first time interval (Frame), wherein the camera is adapted to perform the method of any one of claims 1 to 8.

12. A camera having an image sensor as claimed in claim 9 or having at least one image sensor as claimed in claim 10.

**Fig. 1 Prior Art**

**Fig. 2**

**Fig. 3**

| | | | | | | | | | | |
|---|---|---|---|---|---|---|---|---|---|---|
| Line N | | O | O | O | O | O | O | O | O | O | O |
| Line N+1 | | T | T | T | T | T | T | T | T | T | T |
| Line N+2 | | O | O | O | O | O | O | O | O | O | O |
| Line N+3 | | T | T | T | T | T | T | T | T | T | T |
| Line N+4 | | O | O | O | O | O | O | O | O | O | O |
| | | | | | | | | | | | |

**Fig. 4**

Frame

T0                    T1                    T2                    T3                    T4

Light
Pulse

Measured          Build up Reset Noise          Read out Reset          Build up Reset Noise +          Read out Reset Noise +
                  + Background                  Noise + Background       2x Background + Overlap         2x Background + Overlap

Reset pixel                Stop TG                    Start TG                    Stop TG
(PD & FD)

**Fig. 5**

| | Pixel M | Pixel M+1 | Pixel M+2 | Pixel M+3 | Pixel M+4 | Pixel M+5 | Pixel M+6 | Pixel M+7 | Pixel M+8 | Pixel M+9 |
|---|---|---|---|---|---|---|---|---|---|---|
| Line N | O | BG | O | BG | O | BG | O | BG | O | BG |
| Line N+1 | T | BG | T | BG | T | BG | T | BG | T | BG |
| Line N+2 | O | BG | O | BG | O | BG | O | BG | O | BG |
| Line N+3 | T | BG | T | BG | T | BG | T | BG | T | BG |
| Line N+4 | O | BG | O | BG | O | BG | O | BG | O | BG |

**Fig. 6**

**Fig. 7**

Europäisches
Patentamt

European
Patent Office

Office européen
des brevets

**EUROPEAN SEARCH REPORT**

Application Number

EP 10 30 5638

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/157012 A1 (TACHINO YOSHIHIDE [JP] ET AL) 3 July 2008 (2008-07-03) * paragraph [0181] - paragraph [0197]; figures 4,16 * ----- | 1-12 | INV. H04N13/00 G01S17/89 H04N5/374 |
| X | MIURA H ET AL: "A 100 frame/s CMOS active pixel sensor for 3D-gesture recognition system" IEEE: INTERNATIONAL SOLID - STATE CIRCUITS CONFERENCE, XX, XX, 1 January 1999 (1999-01-01), pages 142-143, XP002141461 * the whole document * ----- | 1 | |

TECHNICAL FIELDS
SEARCHED (IPC)

H04N
G01S

The present search report has been drawn up for all claims

| Place of search | Date of completion of the search | Examiner |
|---|---|---|
| Munich | 19 October 2010 | Penchev, Petyo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 30 5638

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2010

| Patent document cited in search report | Publication date | Patent family member(s) | Publication date |
|---|---|---|---|
| US 2008157012 A1 | 03-07-2008 | JP 2008167178 A | 17-07-2008 |

EPO FORM P0459

For more details about this annex : see Official Journal of the European Patent Office, No. 12/82

**EP 2 405 663 A1**

REFERENCES CITED IN THE DESCRIPTION

**Patent documents cited in the description**

- US 5081530 A, Medina